# EUROPEAN PATENT SPECIFICATION

(11) **EP 0 888 653 B1**
(45) Date of publication and mention of the grant of the patent: **05.06.2002**
(21) Application number: 97915395.4
(22) Date of filing: 19.03.1997
(51) Int. Cl.: H01S 5/10, G02B 6/122, G02B 6/13

(54) **METHOD FOR THE MANUFACTURE OF LASERS WITH TAPERED GUIDE REGION**
HERSTELLUNGSVERFAHREN FÜR LASER MIT SPITZZULAUFENDER WELLENLEITERREGION
PROCEDE DE FABRICATION DE LASERS A GUIDE EN BISEAU

(30) Priority: 22.03.1996 IT TO960219
(43) Date of publication of application: 07.01.1999
(73) Proprietor: Agilent Technologies, Inc. (a Delaware corporation), Palo Alto, CA 94303 (US)
(72) Inventor: FANG, Ruiyu, I-10141 Torino (IT)
(74) Representative: Riederer Freiherr von Paar zu Schönau, Anton
(86) International application number: EP9701385
(87) International publication number: WO9736353

(56) References cited:
- EP-A- 0 599 394
- EP-A- 0 668 516
- IEEE PHOTONICS TECHNOLOGY LETTERS, vol. 3, no. 3, 1 March 1991, pages 210-212, XP000202936 YOSI SHANI ET AL: "BURIED RIB PASSIVE WAVEGUIDE Y JUNCTIONS WITH SHARP VERTEX ON INP"
- ELECTRONICS LETTERS, vol. 30, no. 20, 29 September 1994, pages 1685-1687, XP000474923 LEALMAN I F ET AL: "INGAASP/INP TAPERED ACTIVE LAYER MULTIQUANTUM WELL LASER WITH 1.8DB COUPLING LOSS TO CLEAVED SINGLEMODE FIBRE" cited in the application

## Description

The invention described herein relates to components for optical communications systems and in particular it concerns a method for the manufacture of a solid state laser with laterally tapered guide region.

In optical communications systems it is often necessary to couple a solid state laser with an optical waveguide. One of the problems encountered in this coupling is given by the limited geometric tolerances allowed for correctly positioning the laser emission region with respect to the guide, because of the reduced size of the regions involved. On the contrary, a wide positioning tolerance is an important prerequisite for the future applications of integrated opto-electronic devices in optical communications systems.

In order to reach this goal, it has recently been proposed to taper the active layer of the laser: such tapering makes the effective refractive index of the active layer become close to that of the material making up the adjacent layers and this guarantees increased power transfer to the fibre. Examples of tapered lasers are described, for instance, in the papers "Laterally Tapered InP-InGaAsP Waveguldes for Low-Loss Chip-to-Fiber Butt Coupling: A Comparison of Different Configurations" by R. Zengerie et al., IEEE Photonics Technology Letters, Vol. 7, No. 5, May 1995, and "InGaAsP/InP tapered active layer multiquantum well laser with 1.8 dB coupling loss to cleaved single mode fibre", by LF. Leatman et al., Electronics Letters, 29 September 1994, Vol. 30, No. 20.

A problem encountered in manufacturing tapered guides is that, to obtain satisfactory performance, the narrow end of the tapered region must have a very small width, on the order of 0.1 - 02 µm. To obtain sizes of this order of magnitude, manufacturers employ electron beam writing techniques, as indicated in particular in the article by R. Zengerle mentioned above.

The use of this type of technique has several drawbacks. First, the operation is long and the equipment required is very expensive, and this makes finished devices very expensive. Moreover, since electrically charged particles are used, the technique can be employed without difficulties only to make guides on materials with a certain degree of electrical conductivity, such as semiconductors. It can be employed with many difficulties when the guides are realised on films made of insulating materials (such as SiN₄), which are employed for the manufacture of certain components: in this case, an accumulation of charges would quickly build up, thus preventing the successful completion of the operation.

Using photography techniques with two masks in two successive steps for manufacturing integrated optical components, i. e. a light splitter having a Y junction with a sharp vertex in the Y gusset, is known e. g. from EP-A-0599394 or from IEEE Photonics Technology Letters, Vol. 3, No. 3, 1 March 1991, pages 210-212, Article by Yosi Shani et al. According to the latter literature, one of the masks within the region where the areas of the masks overlap has a tapered region by having chamfers on both sides.

According to the present invention, a method is instead provided wherein the tapered region of the active layer is obtained without the use of costly equipment and without employing electrically charged particles, so that the method can also be used without any problem for insulating materials as well.

The method as defined in the claim is characterised in that the active layer is tapered by means of photolithography techniques, in two successive steps, by forming images respectively of a first and of a second mask each presenting a chamfer with an inclination and profile corresponding to the desired inclination and profile of the corresponding side surface of the tapered region, and in that in the second step the second mask is partially overlaid on the image of the first mask, so that the second image overlaps the first in an area whose shape and size correspond to the desired shape and size of the tapered region.

For the sake of better clarity, reference is made to the enclosed drawings, wherein:
- Figures 1, 2 are a perspective and a cross-section schematic representation of a laser with tapered active region;
- Figure 3 is a top view of the active region;
- Figures 4, 5 show an enlargement of the masks to be used to form the tapered region; and
- Figure 6 is a top view pertaining to a step of the process to form the tapered region.

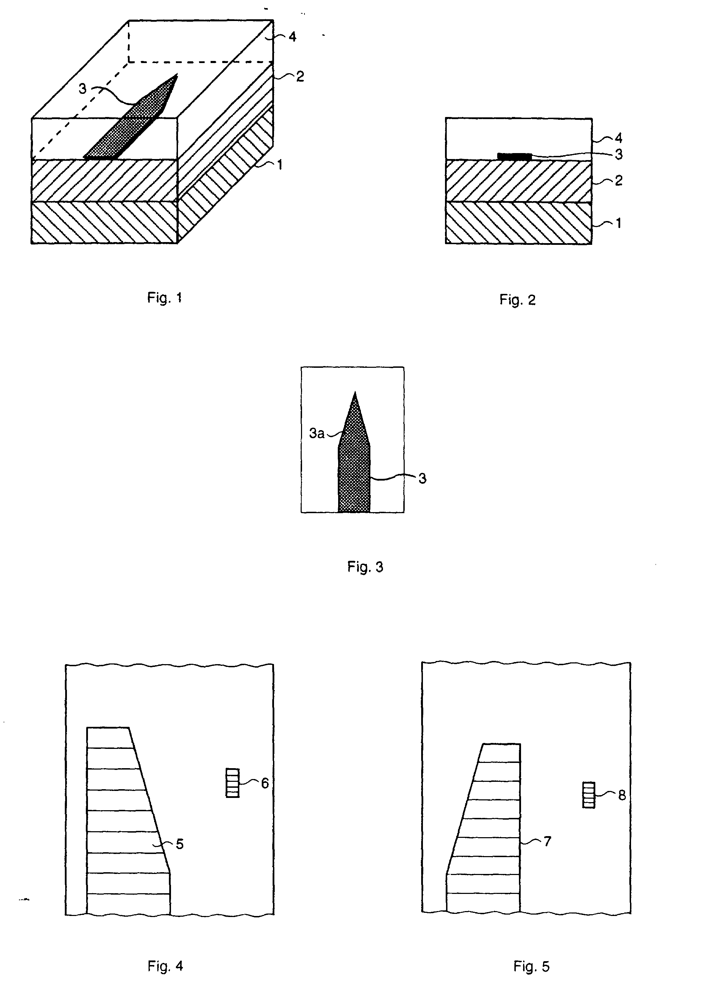

As can be seen in Figures 1 - 3, a semiconductor laser with tapered guide region comprises a substrate 1 made of a suitable material (for instance InP) on which a buffer layer 2 (made of InP with n-type doping), active layer 3 (made of an InGaAsP quaternary alloy) and cover layer 4, again made of InP, are deposited. The active layer is in the form of a strip with a tapered end portion 3a, as can clearly be seen in Figure 3.

It should be specified that the tapered guide could be made either directly on the semiconductor material, or on a film of insulating material such as SiN₄, as required for other laser structures.

According to the invention, the tapered region is obtained through a photolithography process in two steps, and one side of the taper is realised during each step. In the two steps, the masks depicted in Figures 4 and 5 are respectively used.

The masks, formed for example on glass, have each two opaque regions 5, 6 and respectively 7, 8.

The first region 5 (Figure 4) or respectively 7 (Figure 5) is shaped essentially like a rectangular trapezoid (or has at least an end part shaped like a rectangular trapezoid), whose oblique side has the profile and inclination corresponding with those desired for active region taper. In general, the profile of taper 3a (Figure 3) will be rectilinear, although also curvilinear tapers could be formed. Regions 5 and 7 on the two masks essentially mirror each other. Note that, though for the sake of simplicity the oblique side of the trapezoidal regions of the masks is depicted as a continuous profile, in reality it will comprise a series of steps, of extremely small pitch, as the techniques for the realisation of the masks do not allow forming continuous profiles. Typical sizes for the two sides of the trapezoidal region shall be on the order of 1-1.5 µm for the minor base and 3 µm for the major base. The length of the oblique side will depend on the required taper angle.

The second region 6 (Figure 4) or respectively 8 (Figure 5) is an essentially rectangular region constituting a conventional reference or marker for the correct positioning of the mask during the fabrication process.

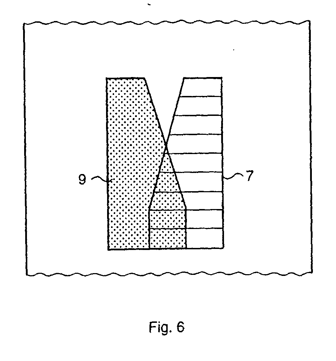

To fabricate the laser, the various layers are formed in a wholly conventional manner. After forming the active layer essentially on the entire buffer layer, the images of region 5 (indicated by 9 in Figure 6) and of marker 6 are formed with conventional photolithography techniques. The same operations are then repeated with the second mask, by overlaying region 7 to image 9, so that the overlap area reproduces the shape of guide 3, as can be seen in Figure 6. At the end of the second step, after the photosensitive material is removed, the active layer is actually reduced to just tapered layer guide 3. The laser is then completed in a wholly conventional manner.

It is evident that, thanks to the manufacture of the guide in two steps, and therefore to the use of two masks, problems stemming from the small size of the tip of the guide are eliminated: the tip is actually obtained as the intersection of the edges of two images and the definition currently achievable with photolithography techniques allows obtaining the sizes mentioned above without any problems.

To obtain the tapered guide, accurate mask positioning is important. For this purpose, as has been stated above, the masks are provided with a reference marker 6 or respectively 8, placed at a pre-set distance from a longitudinal axis of the trapezoidal region (e.g. an axis dividing the minor base in half). Note that development results in an image whose size is slightly reduced with respect to that of the mask, to an extent depending on the particular photo-resist and on the photolithography conditions employed: therefore, both region 7 and marker 8 in the second mask shall have slightly smaller sizes than those of the first mask. Moreover, it will be necessary to take care that the side of marker 8 closer to region 7 is actually at the pre-set distance from the aforesaid longitudinal axis.

It is evident that what has been described above is provided purely by way of non-limiting example and that variations and modifications are possible without departing from the scope of the invention as defined in the claim.

## Claims

1. Method for the manufacture of solid state lasers comprising an active region (3) ending in a laterally tapered region (3a), **characterised in that** said tapered region (3a) is obtained by means of photolithography techniques, in two successive steps, by images respectively of a first and of a second mask (5, 6) each with a chamfer whose inclination and profile correspond to the desired inclination and profile of the corresponding side surface of the tapered region (3a), and **in that** in the second step the second mask (6) is partially overlaid on the image (9) of the first mask (5), so that the second image overlaps the first in an area whose shape and size correspond to the desired shape and size of the tapered region (3a).

## Patentansprüche

1. Verfahren zum Herstellen von Festkörperlasern, die einen aktiven Bereich (3) umfassen, der in einem seitlich spitz zulaufendem Bereich (3a) endet, **dadurch gekennzeichnet, daß** man den spitz zulaufenden Bereich (3a) mit Hilfe fotolithografischer Techniken in zwei aufeinanderfolgenden Schritten durch Abbilder einer ersten bzw. einer zweiten Maske (5, 6) erhält, die jeweils eine Abschrägung umfassen, deren Neigung und Profil der gewünschten Neigung bzw. dem gewünschten Profil der entsprechenden Seitenfläche des spitz zulaufenden Bereichs (3a) entsprechen, und daß man im zweiten Schritt die zweite Maske (6) teilweise so über das Abbild (9) der ersten Maske (5) legt, daß das zweite Abbild das erste in einer Fläche überlappt, deren Form und Größe der gewünschten Form und Größe des spitz zulaufenden Bereichs (3a) entspricht.

## Revendications

1. Procédé de fabrication de lasers semi-conducteurs comprenant une zone active (3) s'achevant en une zone (3a) effilée latéralement, **caractérisé en ce que** ladite zone effilée (3a) est obtenue par des techniques de photolithographie, en deux étapes successives, par des images respectivement d'un premier et d'un deuxième masque (5, 6), chacun étant muni d'un chanfrein dont l'inclinaison et le profil correspondent à l'inclinaison et au profil souhaités de la surface latérale correspondante de la zone effilée (3a), et **en ce que**, lors de la deuxième étape, le deuxième masque (6) est partiellement mis en chevauchement sur l'image (9) du premier masque (5), de sorte que la deuxième image chevauche la première dans une zone dont la forme et la taille correspondent à la forme et à la taille souhaitées de la zone effilée (3a).
